# EUROPÄISCHE PATENTSCHRIFT

(11) **EP 4 416 422 B1**
(45) Veröffentlichungstag und Bekanntmachung des Hinweises auf die Patenterteilung: **23.07.2025**
(21) Anmeldenummer: 22789228.8
(22) Anmeldetag: 27.09.2022
(51) Int. Cl.: F21S 45/47, H05K 1/02, H05K 1/00, F21V 29/70, F21V 29/508, F21V 17/10, H05K 7/20

(54) **LEITERPLATTENANORDNUNG FÜR EINEN KRAFTFAHRZEUGSCHEINWERFER**
CIRCUIT BOARD ASSEMBLY FOR A MOTOR VEHICLE HEADLIGHT
AGENCEMENT DE CARTE DE CIRCUIT IMPRIMÉ POUR UN PHARE DE VÉHICULE AUTOMOBILE

(30) Priorität: 11.10.2021 EP 21201808
(43) Veröffentlichungstag der Anmeldung: 21.08.2024
(73) Patentinhaber: ZKW Group GmbH, 3250 Wieselburg (AT)
(72) Erfinder: KIESLINGER, Dietmar, 2604 Theresienfeld (AT); SCHWARZ, Sebastian, 2763 Pernitz (AT)
(74) Vertreter: Patentanwaltskanzlei Matschnig & Forsthuber OG
(86) Internationale Anmeldenummer: PCT/EP2022/076760
(87) Internationale Veröffentlichungsnummer: WO 2023/061745

(56) Entgegenhaltungen:
- WO-A2-2004/070839
- DE-A1- 102007 034 123
- DE-T5- 112019 001 810
- US-A1- 2019 223 318

## Beschreibung

Die Erfindung betrifft eine Leiterplattenanordnung für einen Kraftfahrzeugscheinwerfer, umfassend eine Leiterplatte und einen Kühlkörper, welcher mit der Leiterplatte in thermischem Kontakt ist und dazu eingerichtet ist, Wärme der Leiterplatte abzuführen, wobei die Leiterplatte und der Kühlkörper zumindest bereichsweise derart mit einem Abstand zueinander beabstandet sind, sodass zwischen der Leiterplatte und dem Kühlkörper ein Spaltraum gebildet ist, wobei die Leiterplatte an dem Kühlkörper mit zumindest einer Befestigungseinrichtung unter Beibehaltung des Spaltraumes befestigt ist, welche Befestigungseinrichtung zumindest Folgendes umfasst:
- eine Befestigungsöffnung mit einer Öffnungsgröße, welche Befestigungsöffnung die Leiterplatte vollständig durchsetzt,
- eine Ausnehmung, welche an dem Kühlkörper angeordnet ist, und welche eine Einführöffnung aufweist, und
- ein Befestigungselement mit einer Längsachse, wobei das Befestigungselement einen Eingriffsabschnitt und einen entlang der Längsachse gegenüberliegenden Anlageabschnitt aufweist,

Die Erfindung betrifft weiters einen Kraftfahrzeugscheinwerfer, umfassend zumindest eine erfindungsgemäße Leiterplattenanordnung.

Um eine Leiterplatte und einen zugehörigen Kühlkörper thermisch miteinander zu verbinden, wird die Leiterplatte an dem Kühlkörper mechanisch angelegt, wobei es unter anderem durch Fertigungsfehler dazu kommen kann, dass die Leiterplatte nicht plan in jedem Bereich an dem Kühlkörper zur Anlage gelangt und bereichsweise ein Spalt bzw. Spaltraum zwischen der Leiterplatte und dem Kühlkörper vorhanden ist.

Gängige Befestigungsmethoden aus dem Stand der Technik zur Befestigung von Leiterplatten an Kühlkörpern sind unter anderem Schrauben oder Nieten.

DE112019001810T5, US2019/223318 A1, DE102007034123 A1 und WO2004/070839 A2 zeigen derartige Leiterplattenanordnungen.

Allerdings kann die Verwendung solcher Befestigungsmittel dazu führen, dass die Leiterplatte im Bereich der Befestigung durch ständigen Anpressdruck der Schrauben oder Nieten verbogen wird und dadurch Bauteile sowie deren elektrische Verbindungen zur Leiterplatte entweder brechen oder die auf der Leiterplatte angeordneten Leiterbahnen und Bauteile gestört bzw. zerstört werden.

Durch diese Deformation, welche besonders stark in der Nähe der Befestigungspunkte auftritt, können elektronische Bauteile nur in einer größeren Distanz zu den Befestigungspunkten assembliert werden. Somit würde eine Befestigungsvorrichtung, welche den Anpressdruck und dadurch auch die Deformation der Leiterplatte reduziert, ermöglichen, dass die Distanz zwischen elektronischem Bauteil und Befestigungspunkt verringert und somit die Gesamtgröße der Leiterplatte minimiert werden kann.

Es ist eine Aufgabe der Erfindung eine verbesserte Leiterplattenanordnung bereitzustellen.

Diese Aufgabe wird dadurch gelöst, dass die Befestigungsöffnung und die Einführöffnung derart überlappend angeordnet sind, dass das Befestigungselement durch die Befestigungsöffnung und die Einführöffnung aufgenommen ist, wobei das Befestigungselement die Leiterplatte über die Befestigungsöffnung durchsetzt,
und wobei das Befestigungselement durch Ausübung einer Kraft an dem Eingriffsabschnitt und einer dazu entgegen gerichteten Gegenkraft an dem Anlageabschnitt derart umgeformt ist, dass das Befestigungselement in der Ausnehmung formschlüssig verklemmt ist und ein erster und einer zweiter Verbreiterungsabschnitt des Befestigungselements ausgebildet ist,
wobei sich der erste Verbreiterungsabschnitt in den Spaltraum zwischen der Leiterplatte und dem Kühlkörper radial zur Längsachse des Befestigungselements erstreckt, wobei sich der erste Verbreiterungsabschnitt über die Öffnungsgröße der Befestigungsöffnung hinaus derart in den Spaltraum erstreckt, sodass der erste Verbreiterungsabschnitt die Leiterplatte abstützt, um den Abstand zwischen der Leiterplatte und dem Kühlkörper im Bereich der Befestigungsöffnung beizubehalten,
und wobei sich der zweite Verbreiterungsabschnitt radial zur Längsachse des Befestigungselements erstreckt, wobei sich der zweite Verbreiterungsabschnitt über die Öffnungsgröße der Befestigungsöffnung hinaus erstreckt, um den Abstand zwischen der Leiterplatte und dem Kühlkörper im Bereich der Befestigungsöffnung beizubehalten,
und wobei die Leiterplatte im Bereich der Befestigungsöffnung zwischen dem ersten und dem zweiten Verbreiterungsabschnitt des Befestigungselements formschlüssig verklemmt ist.

Es kann vorgesehen sein, dass das Befestigungselement stiftförmig ausgebildet ist.

Es kann vorgesehen sein, dass das Befestigungselement aus Kunststoff oder aus einem Metall hergestellt ist, vorzugsweise aus Aluminium oder einer Aluminiumlegierung hergestellt ist.

Generell sei angemerkt, dass das Material des Befestigungselements derart gewählt sein sollte, dass der E-Modul des Befestigungselements kleiner ist als jener des Kühlkörpers. Zusätzlich sollte beachtet werden, dass die Ausdehnungskoeffizienten der unterschiedlichen Materialien so gewählt sind, dass im Anwendungstemperaturbereich auch bei starken Temperaturschwankungen kein Auflösen der Verbindung möglich ist. Des Weiteren sollte bei der Auswahl des Materials des Befestigungselements die im Automobilbereich auftretenden Umwelteinflüsse, wie großer Temperaturschwankungen und Vibrationen, berücksichtigt werden.

Es kann vorgesehen sein, dass in dem Spaltraum ein wärmeleitendes Material angeordnet ist, um eine bessere thermische Anbindung zwischen der Leiterplatte und dem Kühlkörper zu ermöglichen.

Es kann vorgesehen sein, dass die Ausnehmung zumindest einen Hinterschnitt umfasst, sodass das Befestigungselement durch die formschlüssige Verbindung zwischen dem Befestigungselement und der Ausnehmung gegen eine Bewegung entlang der Längsachse gesichert ist.

Es kann vorgesehen sein, dass die Ausnehmung als Sackloch an dem Kühlkörper ausgebildet ist, wobei das Sackloch einen Widerlagerabschnitt aufweist, an welchem Widerlagerabschnitt der Anlageabschnitt des Befestigungselements anliegt und zur Ausübung der Gegenkraft vorgesehen ist.

Es kann vorgesehen sein, dass die Ausnehmung als eine den Kühlkörper vollständig durchsetzende Ausnehmung ausgebildet ist.

Es kann vorgesehen sein, dass die Leiterplattenanordnung ein Widerlagerlement umfasst, an welchem der Anlageabschnitt des Befestigungselements anliegt und zur Ausübung der Gegenkraft vorgesehen ist, wobei das Widerlagerelement durch ein von dem Kühlkörper separates Bauteil gebildet ist. Es kann auch vorgesehen sein, dass nach der Kraftausübung auf das Befestigungselement und nach der Entstehung des daraus resultierenden Formschlusses, besagtes Widerlagerelement bei Bedarf wieder vom Kühlkörper entfernbar ist.

Es kann vorgesehen sein, dass das Befestigungselement in einem Querschnitt parallel zur Längsachse trapezförmig ausgebildet ist, wobei vorzugsweise zwei Schenkelelemente in einem Abstand quer zur Längsachse zueinander an der Basis des Trapezes angeordnet sind.

Es kann vorgesehen sein, dass das Befestigungselement durch Fließpressen umgeformt ist. Unter dem Begriff "Fließpressen" ist zu verstehen, dass aus einer Kraft, welche auf ein Material wirkt, im Material eine Druckbeanspruchung entsteht, die, wenn sie die Druckfließgrenze des Werkstoffes überschreitet, zum Fließen des Werkstoffes führt. Wirkt keine Kraft mehr auf das Bauteil ein, bleibt nach der elastischen Rückfederung eine plastische Verformung des Bauteils zurück.

Es kann vorgesehen sein, dass im Spaltraum zwischen dem Kühlkörper und der Leiterplatte zumindest ein Abstandshalter angeordnet ist, um die Beibehaltung des Spaltraumes zu gewährleisten, vorzugsweise um die Beibehaltung einer minimalen Spalthöhe zwischen dem Kühlkörper und der Leiterplatte zu gewährleisten.

Weiters wird die Aufgabe ebenso gelöst durch einen Kraftfahrzeugscheinwerfer, umfassend zumindest eine erfindungsgemäße Leiterplattenanordnung.

Nachfolgend wird die Erfindung anhand von beispielhaften Zeichnungen näher erläutert. Hierbei zeigt
Fig. 1 eine beispielhafte Leiterplattenanordnung in einer Ansicht von oben, wobei die Leiterplattenanordnung einen Kühlkörper und eine darauf mittels Befestigungseinrichtungen befestigte Leiterplatte umfasst,
Fig. 2A eine beispielhafte Befestigungseinrichtung in einem Querschnitt der Leiterplattenanordnung, wobei die Befestigungseinrichtung eine Befestigungsöffnung in der Leiterplatte, eine Ausnehmung in dem Kühlkörper und ein Befestigungselement umfasst, welches Befestigungselement mittels Ausübung einer Kraft und Gegenkraft verformt ist,
Fig. 2B die beispielhafte Befestigungseinrichtung aus Fig. 2A bevor die Kraft und die Gegenkraft auf das Befestigungselement ausgeübt worden ist,
Fig. 3A die beispielhafte Befestigungseinrichtung aus Fig. 3B nachdem die Kraft und Gegenkraft auf das Befestigungselement ausgeübt worden ist,
Fig. 3B eine weitere beispielhafte Befestigungseinrichtung in einem Zustand bevor Kraft auf das Befestigungselement ausgeübt worden ist,
Fig. 4A ein weiteres Beispiel einer Befestigungseinrichtung vor Kraftausübung zum Verformen des Befestigungselements,
Fig. 4B das Beispiel aus Fig. 4A nach der Verformung des Befestigungselements,
Fig. 5 ein weiteres Beispiel einer Befestigungseinrichtung, wobei die Befestigungseinrichtung weiters Abstandshalter umfasst, und
Fig. 6 mehrere Beispiele für mögliche Befestigungselemente.

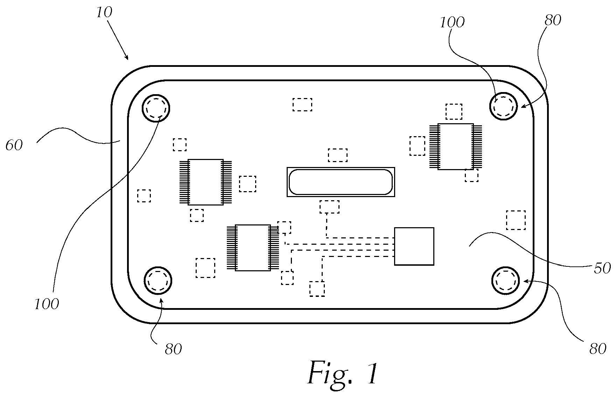

**Fig. 1** zeigt eine beispielhafte Leiterplattenanordnung **10** für einen

Kraftfahrzeugscheinwerfer, umfassend eine Leiterplatte **50** und einen Kühlkörper **60** in einer Ansicht von oben, wobei sich der Kühlkörper mit der Leiterplatte **50** in thermischem Kontakt befindet und dazu eingerichtet ist, die durch den Betrieb der Leiterplatte **50** entstehende Wärme der Leiterplatte **50** abzuführen.

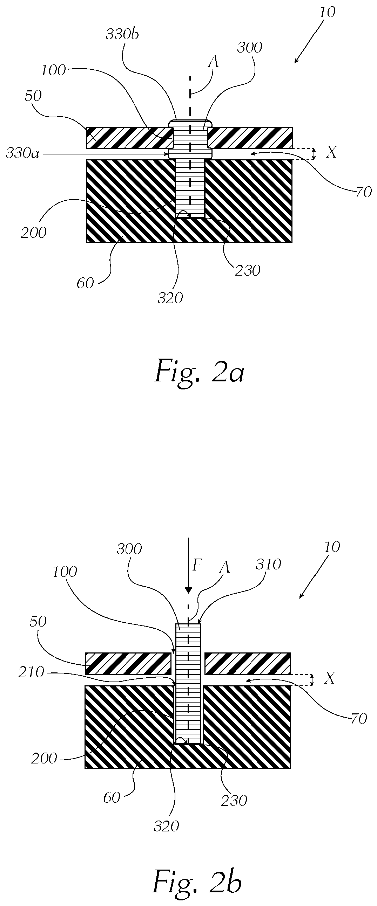

Wie in **Fig. 2a** bzw. **Fig. 2b** ersichtlich, sind die Leiterplatte **50** und der Kühlkörper **60** zumindest bereichsweise derart mit einem Abstand **X** zueinander beabstandet, sodass zwischen der Leiterplatte **50** und dem Kühlkörper **60** ein Spaltraum **70** gebildet ist, wobei die Leiterplatte **50** an dem Kühlkörper **60** mit mehreren Befestigungseinrichtungen **80** unter Beibehaltung des Spaltraumes **70** befestigt ist. Beispiele für mögliche Ausführungen von Befestigungseinrichtungen **80** sind in den nachfolgenden Figuren gezeigt.

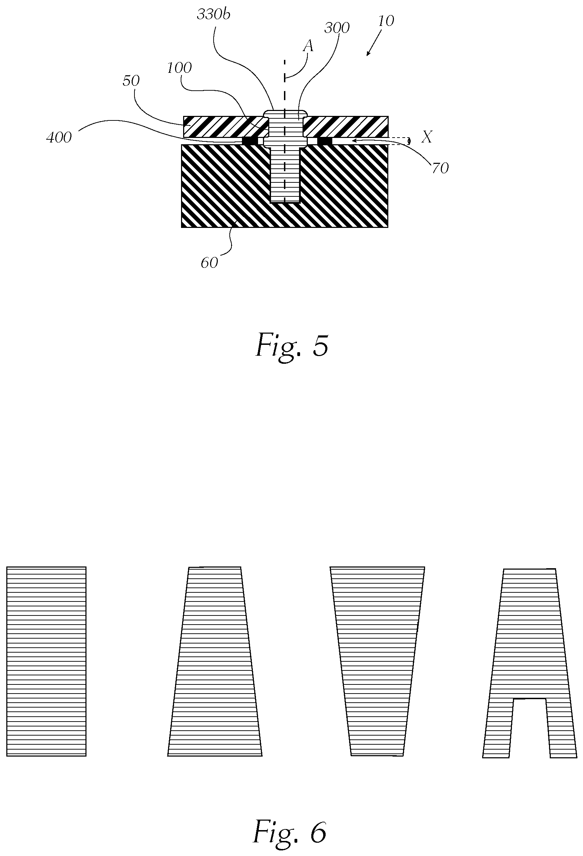

Die Befestigungseinrichtungen **80** umfassen jeweils eine Befestigungsöffnung **100** mit einer Öffnungsgröße, welche Befestigungsöffnung **100** die Leiterplatte **50** vollständig durchsetzt, eine Ausnehmung **200,** welche an dem Kühlkörper **60** angeordnet ist und eine Einführöffnung **210** aufweist, ein Befestigungselement **300** mit einer Längsachse **A,** wobei das Befestigungselement **300** einen Eingriffsabschnitt **310** und einen entlang der Längsachse **A** gegenüberliegenden Anlageabschnitt **320** aufweist, wie beispielhaft in **Fig. 2**A zu sehen ist. In dem gezeigten Beispiel ist das Befestigungselement **300** stiftförmig ausgebildet, wobei auch andere Formen denkbar sind, wie beispielsweise ein in einem Querschnitt parallel zur Längsachse **A** trapezförmiges Befestigungselement. Andere Formen sind ebenso in **Fig. 6** dargestellt.

Das Befestigungselement **300** ist in den gezeigten Beispielen aus Aluminium oder einer Aluminiumlegierung hergestellt.

Dabei sind die Befestigungsöffnung **100** und die Einführöffnung **210** derart überlappend angeordnet, dass das Befestigungselement **300** durch die Befestigungsöffnung **100** und die Einführöffnung **210** aufgenommen ist, wobei das Befestigungselement **300** die Leiterplatte **50** über die Befestigungsöffnung **100** durchsetzt.

Das Befestigungselement **300** ist durch Ausübung einer Kraft **F** an dem Eingriffsabschnitt **310** und einer dazu entgegen gerichteten Gegenkraft an dem Anlageabschnitt **320** derart umgeformt, dass das Befestigungselement **300** in der Ausnehmung **200** formschlüssig verklemmt ist und ein erster und ein zweiter Verbreiterungsabschnitt **330a, 330b** des Befestigungselements **300** ausgebildet ist. Die Umformung ist in den gezeigten Beispielen mittels Fließpressen erfolgt.

In dem gezeigten Beispiel in **Fig. 2A** ist die Ausnehmung **200** als Sackloch an dem Kühlkörper **60** ausgebildet, wobei das Sackloch einen Widerlagerabschnitt **230** aufweist, an welchem Widerlagerabschnitt **230** der Anlageabschnitt **320** des Befestigungselements **300** anliegt und zur Ausübung der Gegenkraft vorgesehen ist.

Der erste Verbreiterungsabschnitt **330a** erstreckt sich in den Spaltraum **70** zwischen der Leiterplatte **50** und dem Kühlkörper **60** radial zur Längsachse **A des** Befestigungselements **300,** wobei sich der erste Verbreiterungsabschnitt **330a** über die Öffnungsgröße der Befestigungsöffnung **100** hinaus derart in den Spaltraum **70** erstreckt, sodass der erste Verbreiterungsabschnitt **330a** die Leiterplatte **50** abstützt, um den Abstand **X** zwischen der Leiterplatte **50** und dem Kühlkörper **60** im Bereich der Befestigungsöffnung **100** beizubehalten.

Der zweite Verbreiterungsabschnitt **330b** erstreckt sich radial zur Längsachse **A des** Befestigungselements **300,** wobei sich der zweite Verbreiterungsabschnitt **330b** über die Öffnungsgröße der Befestigungsöffnung **100** hinaus erstreckt, um den Abstand **X** zwischen der Leiterplatte **50** und dem Kühlkörper **60** im Bereich der Befestigungsöffnung **100** beizubehalten, und um die Leiterplatte **50** gegen eine Bewegung in Richtung entgegen der Ausnehmung **200** zu sichern.

Dabei ist die Leiterplatte **50** zwischen dem ersten und dem zweiten Verbreiterungsabschnitt **330a, 330b** des Befestigungselements **300** formschlüssig verklemmt.

**Fig. 2B** zeigt die Befestigungseinrichtung **80** aus **Fig. 2A** in einem Zustand bevor das Befestigungselement **300** mittels Fließpressen umgeformt bzw. deformiert ist.

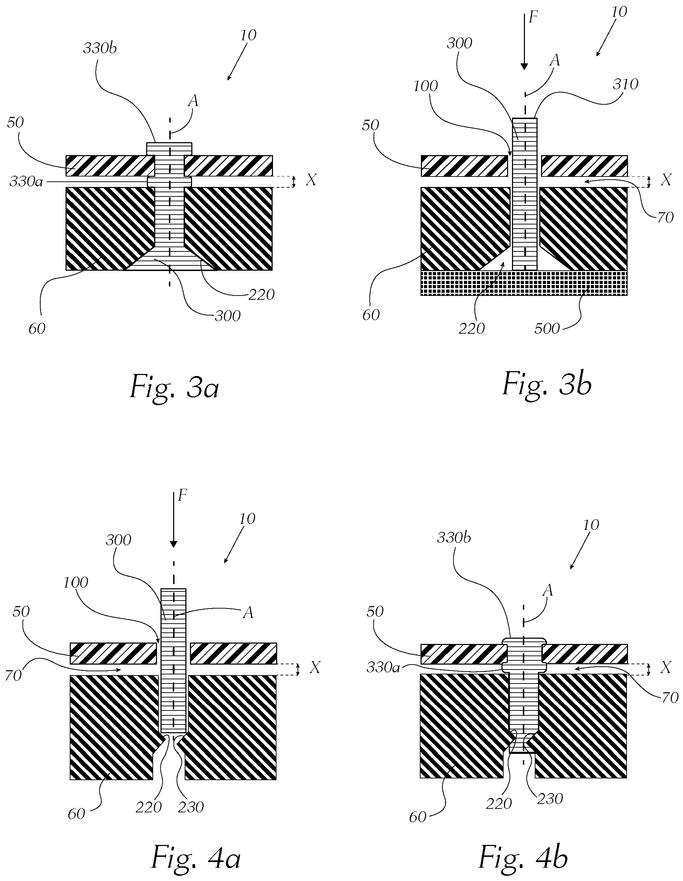

**Fig. 3A** zeigt ein weiteres Beispiel einer Befestigungseinrichtung **80,** wobei das zuvor Gesagte ebenfalls zutrifft. Der Unterschied zum vorherigen Beispiel liegt darin, dass die Ausnehmung **200** als eine den Kühlkörper **60** vollständig durchsetzende Ausnehmung **200** ausgebildet ist, sowie dass die Ausnehmung **200** einen Hinterschnitt **220** umfasst, sodass das Befestigungselement **300** durch die formschlüssige Verbindung zwischen dem Befestigungselement **300** und der Ausnehmung **200** gegen eine Bewegung entlang der Längsachse **A** zusätzlich zum Verklemmen gesichert ist.

**Fig. 3B** zeigt die Befestigungseinrichtung **80** aus **Fig. 3A** in einem Zustand bevor das Befestigungselement **300** mittels Fließpressen umgeformt bzw. deformiert ist, wobei zur Erzeugung der Gegenkraft ein temporär angeordneter Gegenhalter bzw. Widerlagerelement **500** vorgesehen ist.

**Fig. 4A** und **Fig. 4B** zeigen ein weiteres Beispiel einer Befestigungseinrichtung **80,** wobei zur Erzeugung der Gegenkraft die Ausnehmung **200** einen Widerlagerabschnitt **230** umfasst, welcher gleichzeitig als Hinterschnitt im Sinne des vorherigen Beispiels fungiert.

**Fig. 5** zeigt ein weiteres Beispiel einer beispielhaften Befestigungseinrichtung **80,** wobei das zuvor Gesagte ebenfalls auf dieses Beispiel zutrifft. Der Unterschied zu den vorherigen Beispielen, insbesondere aus dem Beispiel gezeigt in **Fig. 2A** bzw. **Fig. 2B** liegt darin, dass die Befestigungseinrichtung **80** Abstandshalter **400** umfasst, welche im Spaltraum **70** zwischen dem Kühlkörper **60** und der Leiterplatte **50** angeordnet sind, um die Beibehaltung des Spaltraumes **70** zusätzlich zu verbessern bzw. zu gewährleisten.

**Fig. 6** zeigt mögliche Ausführungsformen des Befestigungselements **300,** wobei sich der Schutzumfang nicht ausschließlich auf diese hier dargestellten geometrischen Formen bezieht. Eine besonders günstige Form für das Befestigungselement stellt die erste Form von rechts in Fig. 6 dar. Hierbei ist das Befestigungselement in einem Querschnitt parallel zur Längsachse trapezförmig ausgebildet, wobei zwei Schenkelelemente in einem Abstand quer zur Längsachse zueinander an der Basis des Trapezes angeordnet sind.

### LISTE DER BEZUGSZEICHEN

| | |
|---|---|
| Leiterplattenanordnung | 10 |
| Leiterplatte | 50 |
| Kühlkörper | 60 |
| Spaltraum | 70 |
| Befestigungseinrichtungen | 80 |
| Befestigungsöffnung | 100 |
| Ausnehmung | 200 |
| Einführöffnung | 210 |
| Hinterschnitt | 220 |
| Widerlagerabschnitt | 230 |
| Befestigungselement | 300 |
| Eingriffsabschnitt | 310 |
| Anlageabschnitt | 320 |
| Erster Verbreiterungsabschnitt | 330a |
| Zweiter Verbreiterungsabschnitt | 330b |
| Abstandhalter | 400 |
| Gegenhalter | 500 |
| Längsachse | A |
| Abstand | X |

## Patentansprüche

1. Leiterplattenanordnung (10) für einen Kraftfahrzeugscheinwerfer, umfassend eine Leiterplatte (50) und einen Kühlkörper (60), welcher mit der Leiterplatte (50) in thermischem Kontakt ist und dazu eingerichtet ist, Wärme der Leiterplatte (50) abzuführen, wobei die Leiterplatte (50) und der Kühlkörper (60) zumindest bereichsweise derart mit einem Abstand (X) zueinander beabstandet sind, sodass zwischen der Leiterplatte (50) und dem Kühlkörper (60) ein Spaltraum (70) gebildet ist, wobei die Leiterplatte (50) an dem Kühlkörper (60) mit zumindest einer Befestigungseinrichtung (80) unter Beibehaltung des Spaltraumes (70) befestigt ist, welche zumindest eine Befestigungseinrichtung (80) Folgendes umfasst:
- eine Befestigungsöffnung (100) mit einer Öffnungsgröße, welche Befestigungsöffnung (100) die Leiterplatte (50) vollständig durchsetzt,
- eine Ausnehmung (200), welche an dem Kühlkörper (70) angeordnet ist, und welche eine Einführöffnung (210) aufweist, und
- ein Befestigungselement (300) mit einer Längsachse (A), wobei das Befestigungselement (300) einen Eingriffsabschnitt (310) und einen entlang der Längsachse (A) gegenüberliegenden Anlageabschnitt (320) aufweist,
**dadurch gekennzeichnet, dass**
die Befestigungsöffnung (100) und die Einführöffnung (210) derart überlappend angeordnet sind, dass das Befestigungselement (300) durch die Befestigungsöffnung (100) und die Einführöffnung (210) aufgenommen ist, wobei das Befestigungselement (300) die Leiterplatte (50) über die Befestigungsöffnung (100) durchsetzt,
und wobei das Befestigungselement (300) durch Ausübung einer Kraft (F) an dem Eingriffsabschnitt (310) und einer dazu entgegen gerichteten Gegenkraft an dem Anlageabschnitt (320) derart umgeformt ist, dass das Befestigungselement (300) in der Ausnehmung (200) formschlüssig verklemmt ist und ein erster und ein zweiter Verbreiterungsabschnitt (330a, 330b) des Befestigungselements (300) ausgebildet ist,
wobei sich der erste Verbreiterungsabschnitt (330a) in den Spaltraum (70) zwischen der Leiterplatte (50) und dem Kühlkörper (60) radial zur Längsachse (A) des Befestigungselements (300) erstreckt, wobei sich der erste Verbreiterungsabschnitt (330a) über die Öffnungsgröße der Befestigungsöffnung (100) hinaus derart in den Spaltraum (70) erstreckt, sodass der erste Verbreiterungsabschnitt (330a) die Leiterplatte (50) abstützt, um den Abstand (X) zwischen der Leiterplatte (50) und dem Kühlkörper (60) im Bereich der Befestigungsöffnung (100) beizubehalten,
und wobei sich der zweite Verbreiterungsabschnitt (330b) radial zur Längsachse (A) des Befestigungselements (300) erstreckt, wobei sich der zweite Verbreiterungsabschnitt (330b) über die Öffnungsgröße der Befestigungsöffnung (100) hinaus erstreckt, um den Abstand (X) zwischen der Leiterplatte (50) und dem Kühlkörper (60) im Bereich der Befestigungsöffnung (100) beizubehalten, und um die Leiterplatte (50) gegen eine Bewegung in Richtung entgegen der Ausnehmung (200) zu sichern,
und wobei die Leiterplatte (50) zwischen dem ersten und dem zweiten Verbreiterungsabschnitt (330a, 330b) des Befestigungselements (300) formschlüssig verklemmt ist.

2. Leiterplattenanordnung nach Anspruch 1, **dadurch gekennzeichnet, dass** das Befestigungselement (300) stiftförmig ausgebildet ist.

3. Leiterplattenanordnung nach Anspruch 1 oder 2, **dadurch gekennzeichnet, dass** das Befestigungselement (300) aus Kunststoff oder aus einem Metall hergestellt ist, vorzugsweise aus Aluminium oder einer Aluminiumlegierung hergestellt ist.

4. Leiterplattenanordnung nach einem der Ansprüche 1 bis 3, **dadurch gekennzeichnet, dass** die Ausnehmung (200) zumindest einen Hinterschnitt (220) umfasst, sodass das Befestigungselement (300) durch die formschlüssige Verbindung zwischen dem Befestigungselement (300) und der Ausnehmung (200) gegen eine Bewegung entlang der Längsachse (A) gesichert ist.

5. Leiterplattenanordnung nach einem der Ansprüche 1 bis 4, **dadurch gekennzeichnet, dass** die Ausnehmung (200) als Sackloch an dem Kühlkörper (60) ausgebildet ist, wobei das Sackloch einen Widerlagerabschnitt (230) aufweist, an welchem Widerlagerabschnitt (230) der Anlageabschnitt (320) des Befestigungselements (300) anliegt und zur Ausübung der Gegenkraft vorgesehen ist.

6. Leiterplattenanordnung nach einem der Ansprüche 1 bis 4, **dadurch gekennzeichnet, dass** die Ausnehmung (200) als eine den Kühlkörper (60) vollständig durchsetzende Ausnehmung (200) ausgebildet ist.

7. Leiterplattenanordnung nach einem der Ansprüche 1 bis 6, **dadurch gekennzeichnet, dass** das Befestigungselement (300) in einem Querschnitt parallel zur Längsachse (A) trapezförmig ausgebildet ist, wobei vorzugsweise zwei Schenkelelemente in einem Abstand quer zur Längsachse (A) zueinander an der Basis des Trapezes angeordnet sind.

8. Leiterplattenanordnung nach einem der Ansprüche 1 bis 7, **dadurch gekennzeichnet, dass** das Befestigungselement (300) durch Fließpressen umgeformt ist.

9. Leiterplattenanordnung nach einem der Ansprüche 1 bis 8, **dadurch gekennzeichnet, dass** im Spaltraum (70) zwischen dem Kühlkörper (60) und der Leiterplatte (50) zumindest ein Abstandshalter (400) angeordnet ist, um die Beibehaltung des Spaltraumes (70) zu gewährleisten.

10. Leiterplattenanordnung nach einem der Ansprüche 1 bis 9, **dadurch gekennzeichnet, dass** die Leiterplattenanordnung (10) ein Widerlagerelement (500) umfasst, an welchem der Anlageabschnitt (320) des Befestigungselements (300) anliegt und zur Ausübung der Gegenkraft vorgesehen ist, wobei das Widerlagerelement (500) durch ein von dem Kühlkörper separates Bauteil gebildet ist, wobei das Widerlagerelement (500) nach der Kraftausübung auf das Befestigungselement (300) und nach der Entstehung des daraus resultierenden Formschlusses vom Kühlkörper entfernbar ist.

11. Kraftfahrzeugscheinwerfer, umfassend zumindest eine Leiterplattenanordnung (10) nach einem der Ansprüche 1 bis 10.

## Claims

1. Printed circuit board arrangement (10) for a motor vehicle headlight, comprising a printed circuit board (50) and a heat sink (60) which is in thermal contact with the printed circuit board (50) and is designed to dissipate heat from the printed circuit board (50), the printed circuit board (50) and the heat sink (60) being spaced apart from one another by a distance (X) at least in some regions in such a way so that a gap space (70) is formed between the printed circuit board (50) and the heat sink (60), the printed circuit board (50) being fastened to the heat sink (60) by at least one fastening device (80) while maintaining the gap space (70), which at least one fastening device (80) comprises
- a fastening opening (100) with an opening size, which fastening opening (100) completely penetrates the printed circuit board (50),
- a recess (200) which is arranged on the heat sink (70) and which has an insertion opening (210), and
- a fastening element (300) having a longitudinal axis (A), the fastening element (300) having an engagement section (310) and an abutment section (320) located opposite along the longitudinal axis (A),
**characterized in that**
the fastening opening (100) and the insertion opening (210) are arranged to overlap in such a way that the fastening element (300) is received by the fastening opening (100) and the insertion opening (210), the fastening element (300) passing through the printed circuit board (50) via the fastening opening (100),
and wherein the fastening element (300) is deformed by exerting a force (F) at the engagement portion (310) and an opposing force at the contact portion (320) in such a way that the fastening element (300) is positively clamped in the recess (200) and a first and a second widening portion (330a, 330b) of the fastening element (300) are formed,
wherein the first widening portion (330a) extends into the gap space (70) between the printed circuit board (50) and the heat sink (60) radially to the longitudinal axis (A) of the fastening element (300), wherein the first widening portion (330a) extends into the gap space (70) beyond the opening size of the fastening opening (100) in such a manner so that the first widening section (330a) supports the printed circuit board (50) in order to maintain the distance (X) between the printed circuit board (50) and the heat sink (60) in the region of the fastening opening (100),
and wherein the second widening portion (330b) extends radially to the longitudinal axis (A) of the fastening element (300), wherein the second widening portion (330b) extends beyond the opening size of the fastening opening (100) to maintain the distance (X) between the printed circuit board (50) and the heat sink (60) in the region of the fastening opening (100), and to secure the printed circuit board (50) against movement in the direction opposite to the recess (200),
and wherein the printed circuit board (50) is positively clamped between the first and the second widening portion (330a, 330b) of the fastening element (300).

2. Printed circuit board arrangement according to claim 1, **characterized in that** the fastening element (300) is pin-shaped.

3. Printed circuit board arrangement according to claim 1 or 2, **characterized in that** the fastening element (300) is made of plastic or of a metal, preferably made of aluminium or an aluminium alloy.

4. Printed circuit board arrangement according to one of claims 1 to 3, **characterized in that** the recess (200) comprises at least one undercut (220), so that the fastening element (300) is secured against movement along the longitudinal axis (A) by the positive connection between the fastening element (300) and the recess (200).

5. Printed circuit board arrangement according to one of claims 1 to 4, **characterized in that** the recess (200) is designed as a blind hole on the heat sink (60), the blind hole having an abutment section (230), against which abutment section (230) the contact section (320) of the fastening element (300) bears and is provided for exerting the counterforce.

6. Printed circuit board arrangement according to one of claims 1 to 4, **characterized in that** the recess (200) is designed as a recess (200) completely penetrating the heat sink (60).

7. Printed circuit board arrangement according to one of claims 1 to 6, **characterized in that** the fastening element (300) is trapezoidal in cross-section parallel to the longitudinal axis (A), two leg elements preferably being arranged at a distance from one another transversely to the longitudinal axis (A) at the base of the trapezoid.

8. Printed circuit board arrangement according to one of claims 1 to 7, **characterized in that** the fastening element (300) is formed by extrusion.

9. Printed circuit board arrangement according to one of claims 1 to 8, **characterized in that** at least one spacer (400) is arranged in the gap space (70) between the heat sink (60) and the printed circuit board (50) in order to ensure that the gap space (70) is maintained.

10. Printed circuit board arrangement according to one of claims 1 to 9, **characterized in that** the printed circuit board arrangement (10) comprises an abutment element (500) against which the abutment portion (320) of the fastening element (300) bears and is provided for exerting the counterforce, the abutment element (500) being formed by a component separate from the heat sink, the abutment element (500) being removable from the heat sink after the force has been exerted on the fastening element (300) and after the resulting form fit has been created.

11. Motor vehicle headlamp, comprising at least one printed circuit board arrangement (10) according to one of claims 1 to 10.

## Revendications

1. Ensemble de carte de circuit imprimé (10) pour un phare de véhicule automobile, comprenant une carte de circuit imprimé (50) et un corps de refroidissement (60) qui est en contact thermique avec la carte de circuit imprimé (50) et qui est conçu pour évacuer la chaleur de la carte de circuit imprimé (50), la carte de circuit imprimé (50) et le corps de refroidissement (60) étant espacés l'un de l'autre d'une distance (X) au moins par zones, de sorte qu'un espace (70) est formé entre la carte de circuit imprimé (50) et le dissipateur thermique (60), la carte de circuit imprimé (50) étant fixée au dissipateur thermique (60) avec au moins un dispositif de fixation (80) en conservant l'espace (70), lequel au moins un dispositif de fixation (80) comprend :
- une ouverture de fixation (100) avec une taille d'ouverture, laquelle ouverture de fixation (100) traverse complètement la carte de circuit imprimé (50),
- un évidement (200) qui est disposé sur le corps de refroidissement (70) et qui présente une ouverture d'insertion (210), et
- un élément de fixation (300) avec un axe longitudinal (A), l'élément de fixation (300) présentant une section d'engagement (310) et une section d'appui (320) opposée le long de l'axe longitudinal (A),
**caractérisé en ce que**
l'ouverture de fixation (100) et l'ouverture d'introduction (210) sont disposées de manière à se chevaucher de telle sorte que l'élément de fixation (300) est reçu par l'ouverture de fixation (100) et l'ouverture d'introduction (210), l'élément de fixation (300) traversant la carte de circuit imprimé (50) par l'intermédiaire de l'ouverture de fixation (100),
et l'élément de fixation (300) étant déformé par l'exercice d'une force (F) sur la section d'engagement (310) et d'une force antagoniste opposée à celle-ci sur la section d'appui (320) de telle sorte que l'élément de fixation (300) est bloqué par complémentarité de forme dans l'évidement (200) et qu'une première et une deuxième sections d'élargissement (330a, 330b) de l'élément de fixation (300) est formée,
la première section d'élargissement (330a) s'étendant dans l'espace de fente (70) entre la carte de circuit imprimé (50) et le corps de refroidissement (60) radialement par rapport à l'axe longitudinal (A) de l'élément de fixation (300), la première section d'élargissement (330a) s'étendant au-delà de la taille d'ouverture de l'ouverture de fixation (100) de telle sorte dans l'espace de fente (70), de sorte que la première section d'élargissement (330a) supporte la carte de circuit imprimé (50) afin de maintenir la distance (X) entre la carte de circuit imprimé (50) et le dissipateur thermique (60) dans la zone de l'ouverture de fixation (100),
et dans lequel la deuxième section d'élargissement (330b) s'étend radialement par rapport à l'axe longitudinal (A) de l'élément de fixation (300), la deuxième section d'élargissement (330b) s'étendant au-delà de la taille d'ouverture de l'ouverture de fixation (100) afin de maintenir la distance (X) entre la carte de circuit imprimé (50) et le dissipateur thermique (60) dans la zone de l'ouverture de fixation (100), et pour empêcher la carte de circuit imprimé (50) de se déplacer dans la direction opposée à l'évidement (200),
et dans lequel la carte de circuit imprimé (50) est bloquée par complémentarité de forme entre la première et la deuxième section d'élargissement (330a, 330b) de l'élément de fixation (300).

2. Ensemble de cartes de circuits imprimés selon la revendication 1, **caractérisé en ce que** l'élément de fixation (300) est en forme de broche.

3. Ensemble de cartes de circuits imprimés selon la revendication 1 ou 2, **caractérisé en ce que** l'élément de fixation (300) est fabriqué en matière plastique ou en un métal, de préférence en aluminium ou en alliage d'aluminium.

4. Ensemble de cartes de circuits imprimés selon l'une des revendications 1 à 3, **caractérisé en ce que** l'évidement (200) comprend au moins une contre-dépouille (220), de sorte que l'élément de fixation (300) est bloqué contre un mouvement le long de l'axe longitudinal (A) par la liaison par complémentarité de forme entre l'élément de fixation (300) et l'évidement (200).

5. Ensemble de cartes de circuits imprimés selon l'une des revendications 1 à 4, **caractérisé en ce que** l'évidement (200) est réalisé sous la forme d'un trou borgne sur le corps de refroidissement (60), le trou borgne présentant une section de butée (230), section de butée (230) contre laquelle la section d'appui (320) de l'élément de fixation (300) s'applique et est prévue pour exercer la force antagoniste.

6. Ensemble de cartes de circuits imprimés selon l'une des revendications 1 à 4, **caractérisé en ce que** l'évidement (200) est conçu comme un évidement (200) traversant entièrement le corps de refroidissement (60).

7. Ensemble de cartes de circuits imprimés selon l'une quelconque des revendications 1 à 6, **caractérisé en ce que** l'élément de fixation (300) est de forme trapézoïdale dans une section transversale parallèle à l'axe longitudinal (A), de préférence deux éléments de branche étant disposés à une distance l'un de l'autre transversalement à l'axe longitudinal (A) à la base du trapèze.

8. Ensemble de cartes de circuits imprimés selon l'une des revendications 1 à 7, **caractérisé en ce que** l'élément de fixation (300) est déformé par extrusion.

9. Ensemble de cartes de circuits imprimés selon l'une des revendications 1 à 8, **caractérisé en ce qu'**au moins une entretoise (400) est disposée dans l'espace (70) entre le dissipateur thermique (60) et la carte de circuits imprimés (50) afin de garantir le maintien de l'espace (70).

10. Ensemble de cartes de circuits imprimés selon l'une des revendications 1 à 9, **caractérisé en ce que** l'ensemble de cartes de circuits imprimés (10) comprend un élément de butée (500) contre lequel la partie d'appui (320) de l'élément de fixation (300) s'appuie et est prévue pour exercer la force antagoniste, l'élément de butée (500) étant formé par un composant séparé du corps de refroidissement, l'élément de butée (500) pouvant être retiré du corps de refroidissement après l'exercice de la force sur l'élément de fixation (300) et après la création de la liaison par complémentarité de forme qui en résulte.

11. Projecteur de véhicule automobile, comprenant au moins un ensemble de carte de circuit imprimé (10) selon l'une quelconque des revendications 1 à 10.
